# EUROPÄISCHE PATENTSCHRIFT

(11) **EP 2 898 110 B1**
(45) Veröffentlichungstag und Bekanntmachung des Hinweises auf die Patenterteilung: **25.05.2016**
(21) Anmeldenummer: 13791899.1
(22) Anmeldetag: 13.09.2013
(51) Int. Cl.: C23C 14/22, C23C 14/34, C23C 14/50, H01J 37/34

(54) **VORRICHTUNG ZUM BESCHICHTEN EINES SUBSTRATS AUS TEILCHEN**
DEVICE FOR COATING A SUBSTRATE MADE OF PARTICLES
DISPOSITIF SERVANT À RECOUVRIR UN SUBSTRAT PARTICULAIRE

(30) Priorität: 21.09.2012 AT 504062012
(43) Veröffentlichungstag der Anmeldung: 29.07.2015
(73) Patentinhaber: Technische Universität Wien, 1040 Wien (AT)
(72) Erfinder: SCHMID, Gerwin, A-1020 Wien (AT); EISENMENGER-SITTNER, Christoph, A-2352 Gumpoldskirchen (AT); HELL, Johannes, A-3200 Ober-Grafendorf (AT); QUIRCHMAIR, Martin, A-4846 Redlham (AT)
(74) Vertreter: Sonn & Partner Patentanwälte
(86) Internationale Anmeldenummer: PCT/AT2013/050181
(87) Internationale Veröffentlichungsnummer: WO 2014/043728

(56) Entgegenhaltungen:
- GB-A- 2 282 824
- JP-A- 2007 204 786
- SCHMID G ET AL: "Optimization of a container design for depositing uniform metal coatings on glass microspheres by magnetron sputtering", SURFACE AND COATINGS TECHNOLOGY, ELSEVIER, AMSTERDAM, NL, Bd. 205, Nr. 7, 25. Dezember 2010 (2010-12-25), Seiten 1929-1936, XP027533891, ISSN: 0257-8972 [gefunden am 2010-08-24] in der Anmeldung erwähnt

## Beschreibung

Die Erfindung betrifft eine Vorrichtung zum Beschichten eines Substrats aus Teilchen, wie beispielsweise Körnern, Granulaten, Pulvern, Scheibchen, Stäbchen oder Fasern, mittels Kathodenzerstäubung mit einer beweglichen, gegenüber der Horizontalebene schräggestellten Substratschale.

Das Verfahren der Kathodenzerstäubung ist eine Methode zum zerstörungsfreien Beschichten beispielsweise von pulverförmigen oder granulatartigen Substraten.

Die verbreitetsten Varianten zum Erzielen einer möglichst gleichmäßigen Beschichtung eines Substrats sind Wirbelbeschichtung, Hohlkathodenbeschichtung und Stabkathodenbeschichtung. Bei der Wirbelbeschichtung ist aufgrund der notwendig hohen Gasflüsse der Einsatz in Verbindung mit Kathodenzerstäubung nur begrenzt möglich. Bei der Hohlkathodenbeschichtung stellen die Zu- und Abführung des Substrates, welches durch eine vertikal angeordnete hohlzylinderförmige Kathode fällt, Schwierigkeiten dar. Bei der Stabkathodenbeschichtung, bei der sich das Substrat in einer um eine waagrechte Rotationsachse rotierenden Trommel befindet, in deren Mitte die Stabkathode angeordnet ist, sind nur geringe Beschichtungsraten möglich.

Eine Vorrichtung der eingangs angeführten Art, welche eine gegenüber den bekannten Verfahren verbesserte Beschichtung ermöglicht, wurde bereits von G. Schmid et al., "Optimization of a container design for depositing uniform metal coatings on glass microspheres by magnetron sputtering", Surface & Coatings Technology 205 (2010) S. 1929-1936, beschrieben. Die Vorrichtung basiert auf der an sich bekannten Technik des Magnetronsputterns, wobei zusätzlich zu dem (beim Kathodenzerstäuben selbstverständlichen) elektrischen Feld ein magnetisches Feld so angeordnet ist, dass die Ladungsträger in spiralförmigen Bahnen über der Target-Oberfläche kreisen und somit eine höhere Ionisation und letztendlich eine höhere Sputterrate erzielt wird. Bei der gezeigten Vorrichtung ist eine schräggestellte Substratschale gegenüber und unterhalb des Targets angeordnet. Durch Rotieren der Substratschale wird das enthaltene Substrat durchmischt und einem Verkleben der Partikel untereinander oder mit der Behälterwand entgegengewirkt. Die in dem zitierten Artikel getestete Beschichtung von Mikroglaskugeln ist besonders anspruchsvoll, da die hohlen Glaskugeln einerseits mechanisch empfindlicher sind und generell kleine Partikel - aufgrund der geringen Dichte - stärker zum Verkleben neigen als andere, beispielsweise massive, Substrate.

Die US 6,355,146 zeigt ein Beschichtungsverfahren, welches Magnetronsputtern verwendet, wobei eine Substratschale entweder mittels Piezoelementen vibriert oder in der Art eines Schaufelrads gedreht wird.

Die US 6 038 999 A1 zeigt eine Beschichtungsvorrichtung mit einer um 15° geneigten Aufnahmekammer für ein aus losen Teilen bestehendes Substrat. Ein Schütteln des Substrats wird dabei durch die Rotation der Kammer und gegebenenfalls durch zusätzliche Rührstäbe erzielt.

Der in JP 11241157 A gezeigte Substratbehälter rotiert um eine geneigte Achse und enthält ein Sieb bzw. einen Korb, welches bzw. welcher unbeweglich mit dem Behälter verbunden ist. Ein Durchmischen des Substrats wird durch Unterbrechung und Umkehrung der Rotationsbewegung erzielt.

Aus der JP 2007-204786 A ist ein piezoelektronischer Rüttler mit einer Schale bekannt, in der zu beschichtende Teilchen angeordnet werden, wobei der Rüttler auf einer schwenkbaren Platte angeordnet ist.

In GB 2 282 824 A ist eine Anordnung mit einer Schale geoffenbart, die eine Schaukelbewegung ausführt sowie periodischen Stößen ausgesetzt wird. Die Schale kann weiters rotiert werden, wobei in ihr enthaltene Teilchen mittels eines Kamms durchmischt werden.

Es ist Aufgabe der Erfindung, eine Vorrichtung wie eingangs angeführt vorzuschlagen, mit der es - auf konstruktiv möglichst einfache Weise - gelingt, das Verkleben des Substrats zu vermeiden oder zumindest weiter zu reduzieren und ein Lösen des Substrats von der Schale zu ermöglichen. Die Erfindung basiert dabei auf der Idee, der Substratschale Erschütterungen in der Art von Schlägen zuzufügen. Da die Erfindung auf die Beschichtung von Substraten im Mikrometer-Bereich (Partikelgrößen von 4-1000 um) abzielt, soll ein Vibrieren der Substratschale möglichst vermieden werden, da dies häufig zur Verdichtung des Substrats und in der Folge zu verstärktem Verkleben führt. Schließlich soll die Erfindung mit den beim Magnetronsputtern notwendigen niedrigen Gasdrücken kompatibel sein.

Die erfindungsgemäße Vorrichtung der eingangs angeführten Art löst diese Aufgabe, indem die Substratschale lose in einem um eine Rotationsachse rotierbaren, schräggestellten, eine Seitenwand aufweisenden Teller angeordnet ist, wobei eine Außenwand der Substratschale intermittierend mit der Innenseite der Seitenwand des Tellers in Kontakt steht.

Aufgrund der losen Anordnung ist die Substratschale in einer zur Rotationsachse des Tellers senkrechten Tellerebene frei beweglich, und sie kann somit im Teller verschoben und gegenüber dem Teller gedreht werden, wobei die Bewegungsfreiheit durch die Seitenwand des Tellers beschränkt ist. Bei Rotation des Tellers wird aufgrund der Schrägstellung eine Bewegung der Substratschale im und relativ zum Teller durch die Schwerkraft erzwungen und es kommt immer dann zu Erschütterungen, wenn die Substratschale bei dieser Bewegung an die Seitenwand des Tellers stößt. Dies kann beispielsweise dadurch gefördert werden, dass Teller und Substratschale verschiedene Umrissformen aufweisen, etwa wenn die Substratschale rund/oval und der Teller vieleckig (in Draufsicht) ist. Die von der Seitenwand auf die Substratschale ausgeübte Bremskraft pflanzt sich dabei auch auf benachbart der Schalenwand angeordnete Substratpartikel fort, welche sich unter Einwirkung von parallel zur Innenseite der Substratschale wirkenden Kraftkomponenten von der Wand lösen.

Eine abwechselnd rotierende und mit periodischen Erschütterungen durchsetzte Bewegung der Substratschale kann auf einfache Weise erzielt werden, wenn sowohl die Außenwand der Substratschale als auch die Seitenwand des Tellers zylindrisch ist, wobei die Zylinderachsen parallel sind, so dass die Substratschale im Teller zumindest abschnittsweise abrollt, und dass die Seitenwand des Tellers an der Innenseite zumindest ein Mitnahmeelement für die Substratschale aufweist. Durch die zylindrische Form und die parallelen Achsen der beiden Behälter bewegt sich die kleinere Substratschale im größeren Teller, sobald dieser gedreht wird, aufgrund der Schwerkraft immer zum tiefsten Punkt des Tellers. Damit die Schale im Teller rollt (und nicht nur gleitet) und es zu einer ständigen Umwälzung des Schaleninhalts kommt, ist es vorteilhaft, wenn zwischen der Außenwand der Substratschale und der Innenseite der Teller-Seitenwand ein gewisser Reibschluss bzw. eine gewisse Haftung besteht, was beispielsweise durch eine ausreichende Rauhigkeit der Materialien erzielt werden kann. Sobald die Substratschale auf ein Mitnahmeelement stößt, wird die Rollbewegung unterbrochen, und die Substratschale wird so lange mit dem Teller mitbewegt und im Teller angehoben, bis der Schwerpunkt der Schale samt Inhalt sich über das Mitnahmeelement verlagert. Dann rollt die Substratschale über das Mitnahmelement und rollt, fällt oder gleitet im Teller durch die Schwerkraft nach unten, bis sie an die Innenseite der Tellerwand stößt und bei dem plötzlichen Aufprall erschüttert wird. Während einer vollständigen Umdrehung des Tellers wird die Substratschale aufgrund der Relativbewegung im Teller mehr als 360° gedreht.

In Bezug auf das Mitnahmeelement hat sich als vorteilhaft herausgestellt, wenn es durch einen radial nach innen ragenden Vorsprung gebildet ist, wobei die Höhe (Länge) des Vorsprungs kleiner ist als die Differenz zwischen dem Innenradius des Tellers und dem Außenradius der Substratschale. Die Höhe des Vorsprungs bestimmt, wie weit die Substratschale bei der Drehung des Tellers aus dem tiefsten Punkt mitgenommen wird und ein Abrollen der Substratschale über das Mitnahmeelement, d.h. über den Vorsprung, ist nur bei entsprechend geringer Höhe des Mitnahmeelements möglich. Bevorzugt beträgt die Höhe des Vorsprungs zwischen 10 und 20% des Außenradius der Substratschale, da die Schale somit einen Winkel von ca. 25° bis 35° in Rotationsrichtung im Teller mitgenommen wird. Bei der entsprechenden "Fallhöhe" ist das Ausmaß der Erschütterung ein geeigneter Kompromiss zwischen einer effektiven Ablösung von Verklebungen und einer geringen mechanischen Belastung des Substrats.

Um die Härte bzw. das Ausmaß der Erschütterung einstellen zu können, ist es günstig, wenn das Mitnahmeelement radial verstellbar ist. Die Vorrichtung kann somit optimal an die jeweiligen Anforderungen, d.h. je nach Substrat, dessen Dichte, mechanische Stabilität und Verklumpungseigenschaften, dem Beschichtungsmaterial, der Temperatur etc., angepasst werden. Außerdem sind im Fall von mehreren Mitnahmelementen verschiedene Erschütterungsstärken einstellbar.

Eine einfache wie effektive Möglichkeit für die Herstellung eines solchen Mitnahmeelements ist, wenn das Mitnahmeelement von einer Schraube gebildet ist, welche die Seitenwand des Tellers durchquert. Der konstruktive Aufwand zur Herstellung der Vorrichtung ist somit minimal und gleichzeitig ist eine stufenlose Einstellbarkeit der Erschütterung gegeben. Die Schrauben können bei Bedarf einfach eingesetzt, entfernt oder ersetzt werden. Aber selbstverständlich sind auch andere Formen von Mitnahmeelementen denkbar, wie z.B. Rampen, Keile oder Schaufeln, welche einen vergleichbaren Effekt erzielen können.

Bei den oben beschriebenen zylindrischen Formen ist es günstig, wenn das Durchmesserverhältnis von Teller und Substratschale etwa 13:9 beträgt. Dieses Verhältnis, d.h. wenn der Durchmesser der Substratschale etwa 70% des Durchmessers des Tellers beträgt, bietet ausreichend Spielraum für die Dimensionierung des Mitnahmeelements, so dass für die meisten Substrate eine geeignete Erschütterung der Substratschale erzielt werden kann, während gleichzeitig der Platzbedarf der Vorrichtung nicht durch einen verhältnismäßig großen Teller über Gebühr vergrößert ist.

In Hinblick auf das Material der Substratschale ist es vorteilhaft, wenn die Masse der Schale möglichst gering ist, da somit bei gleicher Aufprallgeschwindigkeit eine stärkere Erschütterung des Inhalts erzielt wird. Da die Substratschale außerdem elektrisch leitend und mechanisch widerstandsfähig sein soll sowie den beim Kathodenbeschichten üblichen Temperaturen standhalten muss, ist es günstig, wenn die Substratschale aus Aluminium hergestellt ist, welches darüber hinaus im Vergleich zu anderen Metallen einfach zu bearbeiten ist.

Der Neigungswinkel des Tellers und der Substratschale ist ausschlaggebend für die Beschleunigung der Substratschale im Teller und somit auch für den Grad der Erschütterung beim Aufprall auf die Seitenwand des Tellers. Ein zu großer Neigungswinkel kann allerdings insbesondere beim Aufprall zum Austritt des Substrats aus der Schale führen und begrenzt daher die Menge des zu beschichtenden Substrats in der Substratschale. Unter diesen Erwägungen haben sich Neigungswinkel zwischen 14° und 75°, bevorzugt zwischen 45° und 50°, als besonders geeignet herausgestellt.

Weiters ist es für eine effektive Durchmischung des Substrats günstig, wenn eine Innenwand der Substratschale in einem radial äußeren Abschnitt von der Öffnung aus trichterförmig zulaufend und in einem radial inneren Abschnitt zur Öffnung hin kegelförmig zulaufend ausgebildet ist, so dass ein Übergang zwischen den beiden so gebildeten Kegelabschnitten den tiefsten Bereich der Substratschale bildet. Der Vorteil dieses Aufbaus liegt im Zusammenspiel mit der Neigung bzw. Schrägstellung der Substratschale, da sich dabei jede innere Fläche der Schale während einer vollen Umdrehung zumindest zeitweilig zumindest annährend in der Senkrechten befindet, so dass das Substrat optimal abgleiten kann. Bei dem beschriebenen Aufbau ist bevorzugt der Übergang zwischen dem äußeren trichterförmigen Abschnitt und dem inneren kegelförmigen Abschnitt etwa bei einem halben Innenradius der Substratschale angeordnet, wobei die Neigungswinkel der beiden Abschnitte gegenüber einer senkrecht auf die Rotationsachse stehenden Ebene etwa 45° bzw. -45° betragen. Der radiale Verlauf der Schaleninnenseite beschreibt dabei ein gleichschenkeliges rechtwinkeliges Dreieck, so dass in der Neigung jeder "senkrechte" Abschnitt der Innenfläche einem etwa gleich langen "waagrechten" Abschnitt gegenüberliegt und das abgleitende Substrat optimal aufgefangen wird.

Zur zusätzlichen Durchmischung und zum Aufbrechen etwaiger Substrat-Agglomerationen kann an der Innenwand der Substratschale zumindest ein Mischelement angeordnet sein, das bevorzugt die Form einer Finne aufweist. Insbesondere hat sich herausgestellt, dass eine tangential in Rotationsrichtung angeordnete Finne eine gute Durchmischungswirkung bei gleichzeitig geringer zusätzlicher Verklebung von Substrat an der Finne erzielt. Bei dieser Anordnung wird ein nachteiliges Schaufeln des Substrats vermieden.

### Kurze Beschreibung der Zeichnungen

Die Erfindung wird nachfolgend anhand von besonders bevorzugten Ausführungsbeispielen, auf die sie jedoch nicht beschränkt sein soll, und unter Bezugnahme auf die Zeichnung noch weiter erläutert. In der Zeichnung zeigen dabei im Einzelnen:
Fig. 1 eine seitliche Schnittansicht durch eine erfindungsgemäße Vorrichtung, welche zusammen mit einem Target und einer Antriebseinheit abgebildet ist;
Fig. 2 eine direkte Draufsicht entlang der Rotationsachse des Tellers auf die erfindungsgemäße Vorrichtung;
Fig. 3 einen Ausschnitt aus Fig. 1, der nur die vorliegende Vorrichtung zeigt;
Fig. 4 den Bewegungsablauf der Substratschale in dem Teller während einer Drehung des Tellers um etwa 120° anhand von fünf Stellungen in der Art von Momentaufnahmen;
Fig. 5 schematisch einen Querschnitt eines runden Partikels bzw. eines Mikrokügelchens vor und nach einer Beschichtung;
Fig. 6 schematisch einen Querschnitt eines kantigen Partikels vor und nach einer Beschichtung; und
Fig. 7 schematisch einen Querschnitt eines stabförmigen Partikels vor und nach einer Beschichtung.

### Detaillierte Beschreibung der Zeichnungen

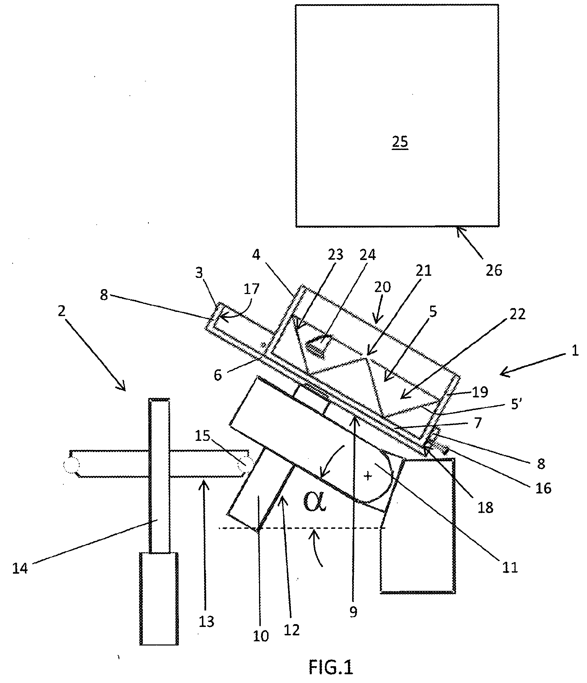

In Fig. 1 ist ein bevorzugtes Ausführungsbeispiel der erfindungsgemäßen Vorrichtung 1 in Verbindung mit einer Antriebseinheit 2 angeordnet gezeigt.

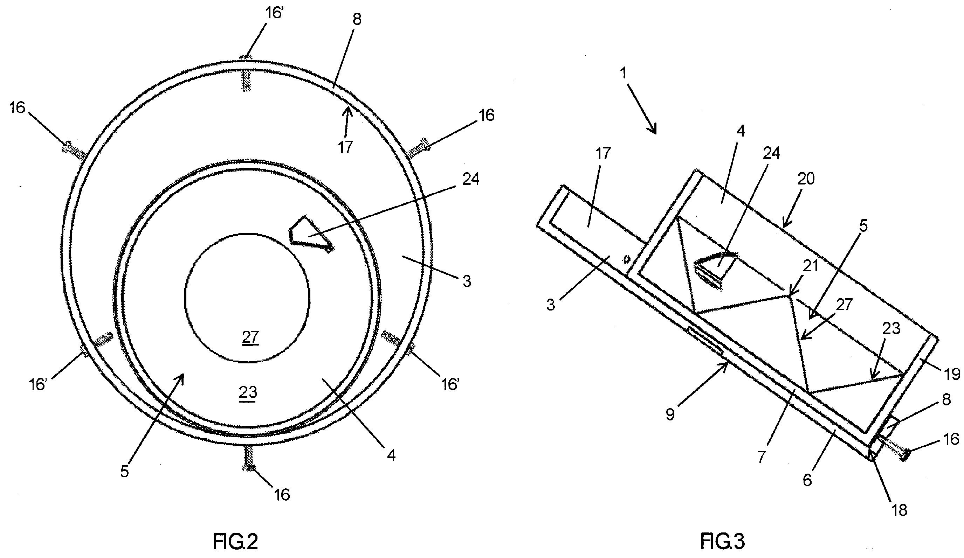

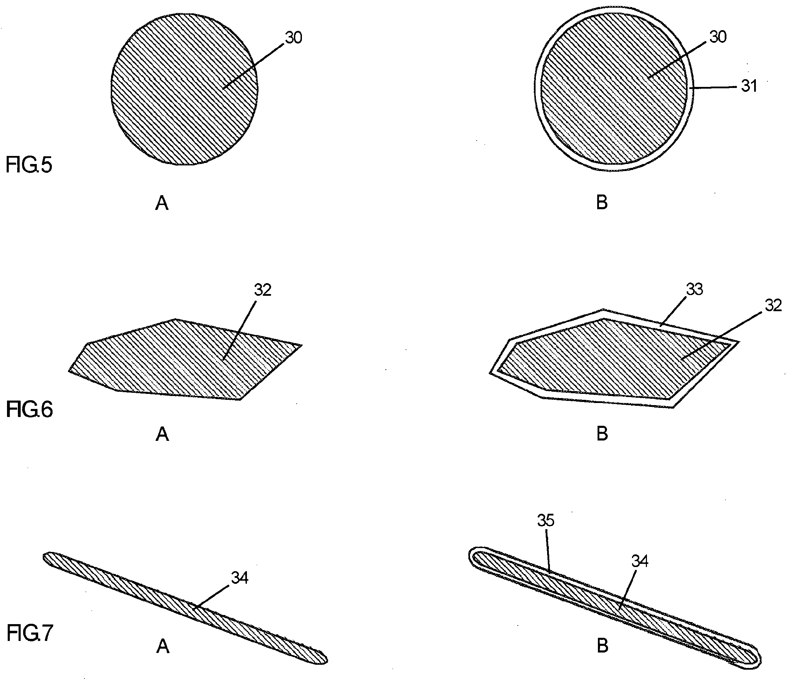

Die Vorrichtung 1 ist, wie auch aus Fig. 3 hervorgeht, im Wesentlichen aus zwei ineinander angeordneten, zu einer Seite offenen Behältern 3, 4 aufgebaut. Der innere Behälter 4, auch Innenschale, Substratschale oder einfach nur Schale genannt, ist in der Art eines Topfs oder einer Trommel ausgebildet, mit einer abschnittsweise kegel- bzw. trichterförmigen Innenseite oder Bodenform 5. In der Schale 4 ist im Betrieb das zu beschichtende Gut (nicht gezeigt), z.B. ein Substrat, wie in Fig. 5 bis 7 gezeigt, aufgenommen. Der innere Behälter 4 ist kleiner als der äußere Behälter 3 und ist in Fig. 1 in dem äußeren, größeren Behälter 3, auch Außenschale oder - zur besseren Unterscheidung - Teller genannt, lose angeordnet. In dem dargestellten Beispiel weisen sowohl der Teller 3 als auch die Schale 4 einen ebenen Boden 6 bzw. 7 auf, so dass der (Außen-)Boden 7 der Schale 4 vollständig an dem (Innen-)Boden 6 des Tellers 3 anliegt. Bei einer Bewegung des Tellers 3 kann der Boden 7 der Schale 4 daher über den Tellerboden 6 gleiten. Die Seitenwand 8 des Tellers 3 verhindert, dass die Substratschale 4 zufolge der Schrägstellung aus dem Teller 3 fällt oder rutscht.

Der Teller 3 ist gemäß Fig. 1 an seiner Unterseite 9 im Mittelpunkt mit einer Drehwelle 10 verbunden. Die Drehwelle 10 ist in einem verschwenkbaren Ausleger 11 der Antriebseinheit 2 gelagert und ragt durch diesen hindurch, so dass der Neigungswinkel des Tellers 3 über eine Verschwenkung des Auslegers 11 einstellbar ist. Auf einer dem Teller 3 gegenüberliegenden Rückseite 12 des Auslegers 11 ist die Drehwelle 10 z.B. mit einem Reibradantrieb 13 verbunden, dessen Welle 14 mit einem außerhalb der Vakuumkammer angeordneten Motor (nicht gezeigt) verbunden ist, und der einen O-Ring-förmigen Reibring 15 aufweist. Eine Drehung des Reibradantriebs 13 führt daher zu einer Rotation des schräggestellten Tellers 3 um die Achse der Welle 10. Wenn der Neigungswinkel des Tellers 3 verändert wird, indem der entsprechende Ausleger 11 gelöst und im Winkel α verstellt wird, kann gegebenenfalls der Reibradantrieb 13 entsprechend angepasst werden, wobei die Höhe des O-Rings 15 derart eingestellt wird, dass der Kontakt zwischen dem O-Ring 15 des Reibradantriebs 13 und der Drehwelle 10 des Tellers 3 erhalten bleibt.

In der Seitenwand 8 des Tellers 3 ist eine Schraube 16 ersichtlich (vgl. Fig. 3), welche so weit radial nach außen gedreht ist, dass sie sich nicht über die Innenseite 17 der Seitenwand 8 erhebt. Daher bildet die Schraube 16 in dem hier dargestellten Zustand kein Mitnahmeelement und die Schale 4 kann im Teller 3 bis zur tiefsten Stelle 18 gleiten, wo die Außenwand 19 der Schale 4 mit der Innenseite 17 der Seitenwand 8 des Tellers 3 in Kontakt steht. Die Seitenwand 8 des Tellers 3 reicht nur etwa bis zu einem Drittel der Höhe der Außenwand 19 der Substratschale 4, was bei den bevorzugten Neigungswinkeln von 14° bis 75°, insbesondere 45° bis 50°, vollkommen ausreichend ist, um ein Herausfallen der Schale 4 aus dem Teller 3 zu verhindern.

Die Innenwand 5' der Substratschale 4 ist unterhalb einer bestimmten Höhe von außen bis etwa zum halben Radius trichterförmig nach unten, d.h. von der Öffnung 20 zum Boden 7, zulaufend und erhebt sich ab dem halben Radius nach innen umgekehrt vom Boden 7 zur Öffnung 20 hin kegelförmig bis zum Mittelpunkt 21. Sie bildet somit eine ringförmige Vertiefung 22 mit einem dreieckförmigen Querschnitt. Im äußeren, trichterförmigen Abschnitt 23 ist ein Mischelement 24 in Form einer Finne tangential in Drehrichtung angeordnet.

Oberhalb der Schalenöffnung 20 ist in an sich bekannter Weise ein Target 25 angeordnet, von dessen Oberfläche 26 in üblicher - und hier daher nicht weiter zu beschreibender - Weise das Beschichtungsmaterial mittels Magnetronsputtern abgetragen und auf die Substratschale 4 bzw. auf das Substrat aufgebracht wird. Die aus Aluminium bestehende und somit leitende Substratschale 4 ist gewöhnlich über den Teller 3 und die Antriebseinheit 2 mit Masse verbunden. Die Wandstärke der Schale 4 kann beispielsweise etwa 3 mm betragen.

In Fig. 2 ist eine Draufsicht auf die Vorrichtung 1 dargestellt, wobei die unterschiedlichen Durchmesser der Substratschale 4 und des Tellers 3 ersichtlich sind. In der Seitenwand 8 des Tellers 3 sind in diesem Beispiel sechs Schrauben 16 in regelmäßigen Winkelabständen angeordnet, welche die Seitenwand 8 durchqueren. Lediglich drei Schrauben 16 sind weit genug durch die Seitenwand 8 gedreht, dass sie von der Innenseite 17 radial nach innen ragen und somit Mitnahmeelemente 16' bilden. Da diese drei Schrauben-Mitnahmeelemente 16' hier vollständig hinein geschraubt sind, weisen sie eine maximale Höhe auf. In der in Fig. 2 gezeigten Draufsicht auf die Substratschale 4 ist außerdem die Aufteilung der Innenseite 5 in einen radial äußeren, trichterförmigen Abschnitt 23 und einen radial inneren, kegelförmigen Abschnitt 27 und die Anordnung der Finne 24 im radial äußeren Abschnitt 23 erkennbar.

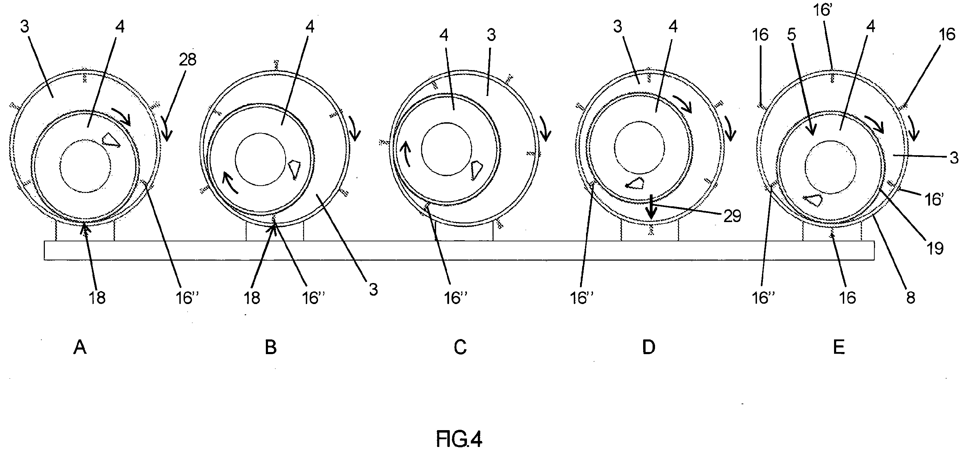

Der Bewegungsablauf der Schale 4 im Teller 3 bei einer Teilumdrehung des Tellers 3 ist in schematischer Schrägansicht in Fig. 4 und deren Unterfiguren A-E gezeigt. Fig. 4A entspricht der oben beschriebenen und in den Fig. 1-3 dargestellten Stellung, wobei die Substratschale 4 am tiefsten Punkt 18 des Tellers 3 angeordnet ist. Wird der Teller 3 ausgehend von Fig. 4A um etwa 60° im Uhrzeigersinn 28 gedreht, ergibt sich die in Fig. 4B gezeigte Stellung. Dabei wurde die Schale 4 von einer Schraube 16" mitgenommen und aus dem tiefsten Punkt 18 des Tellers 3 angehoben und gleichzeitig verdreht. Der Schwerpunkt der Schale 4 samt Inhalt befindet sich hier allerdings noch auf derselben Seite des Mitnahmeelements 16" wie in Fig. 4A.

Das ändert sich bei einer weiteren Drehung des Tellers 3 um etwa 30°, wonach die in Fig. 4C gezeigte Stellung erreicht ist. Die Schale 4 wurde hier ebenfalls entsprechend weiter gedreht und beginnt nun, über die Spitze der Schraube 16" abzurollen.

In der Situation gemäß Fig. 4D ist die Schale 4 beinahe vollständig über die Schraube 16" abgerollt und sie erfährt aufgrund der Schwerkraft eine Beschleunigung (Pfeil 29) nach unten bzw. entlang des Tellerbodens 6, mit dem sie weiterhin in Kontakt steht.

In Fig. 4E hat die Schale 4 die Seitenwand 8 des Tellers 3 erreicht und wird abgebremst. Das abrupte Abbremsen löst eine Erschütterung der Schale 4 und des Substrats aus, wie bei einem Schlag auf die Außenwand 19 der Schale 4.

Aus dem beschriebenen Ablauf wird klar, dass die Höhe des Mitnahmeelements 16" den Winkel bestimmt, bei dem der Schwerpunkt der Schale 4 über die Spitze des Mitnahmeelements 16" wandert und somit die Fallhöhe und die Erschütterung beim Aufprall.

Unter der Annahme einer konstanten Winkelgeschwindigkeit des Tellers 3 wiederholt sich beim gezeigten Beispiel der beschriebene Vorgang bei einer vollständigen Umdrehung des Tellers 3 für jede Schraube 16', 16", d.h. insgesamt drei Mal, da die Höhe aller drei Schrauben 16', 16" gleich ist. Falls Erschütterungen verschiedener Intensität erwünscht sind, können die Schrauben 16, 16', 16" auf verschiedene Höhen eingestellt werden. Es ist günstig, darauf zu achten, dass die Anordnung der Schrauben 16, 16', 16" und das Durchmesserverhältnis von Schale 4 und Teller 3 so gewählt sind, dass die Erschütterung in möglichst vielen verschiedenen Stellungen der Schale 4 eintritt. Eine periodisch immer auf dieselbe(n) Stelle(n) aufschlagende Schale 4 könnte einerseits langfristig zu Beschädigungen der Schale 4 führen und bedeutet andererseits, dass manche Bereiche der Innenseite 5 von der Ablösewirkung der Erschütterung weniger betroffen sind als andere.

Zur Illustration der erzielten gleichmäßigen Beschichtung sind in Fig. 5-7 Beispiele für unbeschichtetes und beschichtetes Substrat verschiedener Struktur - jeweils nebeneinander - dargestellt.

Fig. 5A zeigt schematisch eine unbeschichtete Mikrokugel 30, vergleichbar hohlen Mikroglaskugeln oder Panzerglaskugeln. Nach einer Beschichtung in der Vorrichtung 1 ist die in Fig. 5B gezeigte Mikrokugel 30 in eine Schicht 31 des Targetmaterials eingehüllt, welche eine gleichmäßige Stärke aufweist.

Ein vergleichbares Ergebnis kann auch für ein kantiges Partikel 32 oder Granulate, wie Diamanten oder Wolframcarbidpartikeln, gemäß Fig. 6A erzielt werden. Die entsprechende, in Fig 6B gezeigte Beschichtung 33 weist zwar geringfügige Unregelmäßigkeiten auf, erzielt aber ebenso eine vollständige Umhüllung des Substrats 32.

Auch eine gleichmäßige Beschichtung von Mikrofasern, z.B. Karbonfasern, oder faser- oder stäbchenartigen Substraten, wie die in Fig. 7A gezeigte Faser 34, kann mit der Vorrichtung 1 ohne wesentliches Verkleben des Substrats oder zwischen Substrat und Substratschale 4 erzielt werden. Die in Fig. 7B gezeigte beschichtete Faser 34 gemäß Fig. 7A weist eine einhüllende Schicht 35 des Targetmaterials auf.

In allen Fällen weist das Substrat nach der Beschichtung eine einheitliche Oberfläche bestehend aus dem gewählten Targetmaterial auf.

Neben den dargestellten Beispielen einer runden Schale 4 und eines runden Tellers 3 sind selbstverständlich auch andere Formen denkbar. So wurde beispielsweise mit einer quadratischen Tellerform experimentiert, wobei die ebenen Seitenwände vergleichbar den Mitnahmeelementen funktionieren. Die Schale bewegt sich dabei immer in die tiefste Ecke des Tellers. Wird der Teller gedreht, wobei die Schale mitgeführt wird, und eine andere Ecke erreicht einen tieferen Punkt als jene, in der sich die Schale befindet, gleitet oder rollt die Schale zu dieser neuen Ecke entlang der verbindenden Seitenwand und stößt dort an die dazu senkrechte Seitenwand, was die erfindungsgemäße Erschütterung bewirkt. Allerdings sind runde Behälter 3, 4 im Allgemeinen einfacher und wirtschaftlicher herzustellen, weshalb sie hier als bevorzugte Ausführungen beschrieben wurden.

## Patentansprüche

1. Vorrichtung (1) zum Beschichten eines Substrats aus Teilchen mittels Kathodenzerstäubung mit einer beweglichen, gegenüber der Horizontalebene schräggestellten Substratschale (4), ***dadurch gekennzeichnet, dass*** die Substratschale (4) lose in einem um eine Rotationsachse (10) rotierbaren, schräggestellten, eine Seitenwand (8) aufweisenden Teller (3) angeordnet ist, wobei eine Außenwand (19) der Substratschale (4) intermittierend mit der Innenseite (17) der Seitenwand (8) des Tellers (3) in Kontakt steht.

2. Vorrichtung (1) nach Anspruch 1, **dadurch gekennzeichnet, dass** sowohl die Außenwand (19) der Substratschale (4) als auch die Seitenwand (8) des Tellers (3) zylindrisch ist, wobei die Zylinderachsen parallel sind, so dass die Substratschale (4) im Teller (3) zumindest abschnittsweise abrollt, und dass die Seitenwand (8) des Tellers (3) an der Innenseite (17) zumindest ein Mitnahmeelement (16') für die Substratschale (4) aufweist.

3. Vorrichtung (1) nach Anspruch 2, **dadurch gekennzeichnet, dass** das Mitnahmeelement (16') durch einen radial nach innen ragenden Vorsprung gebildet ist, wobei die Höhe des Vorsprungs kleiner ist als die Differenz zwischen dem Innenradius des Tellers (3) und dem Außenradius der Substratschale (4) und bevorzugt zwischen 10 und 20% des Außenradius der Substratschale (4) beträgt.

4. Vorrichtung (1) nach Anspruch 2 oder 3, **dadurch gekennzeichnet, dass** das Mitnahmeelement (16') radial verstellbar ist.

5. Vorrichtung (1) nach einem der Ansprüche 2 bis 4, **dadurch gekennzeichnet, dass** das Mitnahmeelement (16') von einer Schraube gebildet ist, welche die Seitenwand (8) des Tellers (3) durchquert.

6. Vorrichtung (1) nach einem der Ansprüche 2 bis 5, **dadurch gekennzeichnet, dass** das Durchmesserverhältnis von Teller (3) und Substratschale (4) etwa 13:9 beträgt.

7. Vorrichtung (1) nach einem der Ansprüche 1 bis 6, **dadurch gekennzeichnet, dass** die Substratschale (4) aus Aluminium hergestellt ist.

8. Vorrichtung (1) nach einem der Ansprüche 1 bis 7, **dadurch gekennzeichnet, dass** der Neigungswinkel des Tellers (3) und der Substratschale (4) zwischen 14° und 75°, bevorzugt zwischen 45° und 50°, beträgt.

9. Vorrichtung (1) nach einem der Ansprüche 1 bis 8, **dadurch gekennzeichnet, dass** eine Innenwand (5') der Substratschale (4) in einem radial äußeren Abschnitt (23) von der Öffnung (20) aus trichterförmig zulaufend und in einem radial inneren Abschnitt (27) zur Öffnung (20) hin kegelförmig zulaufend ausgebildet ist, so dass ein Übergang zwischen den beiden so gebildeten Kegelabschnitten (23, 27) den tiefsten Bereich der Substratschale (4) bildet.

10. Vorrichtung (1) nach Anspruch 9, **dadurch gekennzeichnet, dass** der Übergang zwischen dem äußeren trichterförmigen Abschnitt (23) und dem inneren kegelförmigen Abschnitt (27) etwa bei einem halben Innenradius der Substratschale (4) angeordnet ist und die Neigungswinkel der beiden Abschnitte (23, 27) gegenüber einer senkrecht auf die Rotationsachse (10) stehenden Ebene etwa 45° bzw. -45° betragen.

11. Vorrichtung nach einem der Ansprüche 1 bis 10, **dadurch gekennzeichnet, dass** an der Innenwand (5') der Substratschale (4) zumindest ein Mischelement (24) angeordnet ist, das bevorzugt die Form einer Finne aufweist.

## Claims

1. A device (1) for coating a substrate of particles by means of cathode sputtering using a movable substrate dish (4) tilted relative to the horizontal plane, **characterized in that** the substrate dish (4) is loosely arranged in a tilted plate (3) that is rotatable about an axis of rotation (10) and has a side wall (8), wherein an outer wall (19) of the substrate dish (4) is intermittently in contact with the inner side (17) of the side wall (8) of the plate (3).

2. The device (1) according to claim 1, **characterized in that** both the outer wall (19) of the substrate dish (4) and the side wall (8) of the plate (3) are cylinder-shaped with the cylinder axes extending in parallel so as to make the substrate dish (4) roll off within the plate (3) at least in sections, and that the side wall (8) of the plate (3) comprises at least one tappet member (16') for the substrate dish (4) on the inner side (17).

3. The device (1) according to claim 2, **characterized in that** the tappet member (16') is formed by a radially inwardly protruding projection, wherein the height of the projection is smaller than the difference between the inner radius of the plate (3) and the outer radius of the substrate dish (4), preferably being between 10 and 20% of the outer radius of the substrate dish (4).

4. The device (1) according to claim 2 or 3, **characterized in that** the tappet member (16') is radially adjustable.

5. The device (1) according to any one of claims 2 to 4, **characterized in that** the tappet member (16') is formed by a screw passing through the side wall (8) of the plate (3).

6. The device (1) according to any one of claims 2 to 5, **characterized in that** the plate-(3)-to-substrate-dish-(4) diameter ratio is about 13:9.

7. The device (1) according to any one of claims 1 to 6, **characterized in that** the substrate dish (4) is made of aluminum.

8. The device (1) according to any one of claims 1 to 7, **characterized in that** the tilt angle of the plate (3) and the substrate dish (4) is between 14° and 75°, preferably between 45° and 50°.

9. The device (1) according to any one of claims 1 to 8, **characterized in that** an inner wall (5') of the substrate dish (4) in a radially outer portion (23) is designed to taper from the opening (20) in a funnel-shaped fashion, and in a radially inner portion (27) is designed to conically taper to the opening (20), so that a transition between the two thus formed conical portions (23, 27) forms the lowest zone of the substrate dish (4).

10. The device (1) according to claim 9, **characterized in that** the transition between the outer, funnel-shaped portion (23) and the inner, conical portion (27) is located approximately at half an inner radius of the substrate dish (4), the tilt angles of the two portions (23, 27) relative to a plane extending perpendicular to the axis of rotation (10) being about 45° and -45°, respectively.

11. The device (1) according to any one of claims 1 to 10, **characterized in that** at least one mixing element (24), preferably in the form of a fin, is arranged on the inner wall (5') of the substrate dish (4).

## Revendications

1. Dispositif (1) servant à recouvrir un substrat particulaire au moyen d'une pulvérisation cathodique avec une coque de substrat (4) mobile placée en biais par rapport au plan horizontal, ***caractérisé en ce que*** la coque de substrat (4) est disposée de façon lâche dans un plateau (3) pouvant tourner autour d'un axe de rotation (10), placé en biais, présentant une paroi latérale (8), une paroi extérieure (19) de la coque de substrat (4) étant en contact intermittent avec le côté intérieur (17) de la paroi latérale (8) du plateau (3).

2. Dispositif (1) selon la revendication 1, **caractérisé en ce que** aussi bien la paroi extérieure (19) de la coque de substrat (4) que la paroi latérale (8) du plateau (3) sont cylindriques, les axes de cylindre étant parallèles de telle sorte que la coque de substrat (4) roule au moins par tronçons dans le plateau (3), et **en ce que** la paroi latérale (8) du plateau (3) présente sur le côté intérieur (17) au moins un élément d'entraînement (16') pour la coque de substrat (4).

3. Dispositif (1) selon la revendication 2, **caractérisé en ce que** l'élément d'entraînement (16') est formé d'une saillie dépassant radialement vers l'intérieur, la hauteur de la saillie étant inférieure à la différence entre le rayon intérieur du plateau (3) et le rayon extérieur de la coque de substrat (4) et étant de préférence comprise entre 10 et 20 % du rayon extérieur de la coque de substrat (4).

4. Dispositif (1) selon la revendication 2 ou 3, **caractérisé en ce que** l'élément d'entraînement (16') est réglable radialement.

5. Dispositif (1) selon l'une des revendications 2 à 4, **caractérisé en ce que** l'élément d'entraînement (16') est formé d'une vis qui traverse la paroi latérale (8) du plateau (3).

6. Dispositif (1) selon l'une des revendications 2 à 5, **caractérisé en ce que** le rapport de diamètre du plateau (3) et de la coque de substrat (4) est égal à environ 13:9.

7. Dispositif (1) selon l'une des revendications 1 à 6, **caractérisé en ce que** la coque de substrat (4) est fabriquée en aluminium.

8. Dispositif (1) selon l'une des revendications 1 à 7, **caractérisé en ce que** l'angle d'inclinaison du plateau (3) et de la coque de substrat (4) est compris entre 14° et 75°, de préférence entre 45° et 50°.

9. Dispositif (1) selon l'une des revendications 1 à 8, **caractérisé en ce qu'**une paroi intérieure (5') de la coque de substrat (4) est constituée, dans un tronçon (23) extérieur radialement, en forme d'entonnoir à partir de l'ouverture (20) et, dans un tronçon intérieur radialement (27), en forme de cône dirigé vers l'ouverture (20), de telle sorte qu'une transition entre les deux tronçons coniques (23, 27) ainsi formés forme la zone la plus basse de la coque de substrat (4).

10. Dispositif (1) selon la revendication 9, **caractérisé en ce que** la transition entre le tronçon (23) extérieur en forme d'entonnoir et le tronçon (27) intérieur en forme de cône est disposée environ à un demi-rayon intérieur de la coque de substrat (4), et les angles d'inclinaison des deux tronçons (23, 27) par rapport à un plan situé perpendiculairement sur l'axe de rotation sont d'environ 45° ou respectivement -45°.

11. Dispositif selon l'une des revendications 1 à 10, **caractérisé en ce que**, sur la paroi intérieure (5') de la coque de substrat (4), il est disposé au moins un élément mélangeur (24) qui présente de préférence la forme d'un aileron.
